# EUROPÄISCHE PATENTSCHRIFT

(11) **EP 0 373 377 B1**
(45) Veröffentlichungstag und Bekanntmachung des Hinweises auf die Patenterteilung: **23.03.1994**
(21) Anmeldenummer: 89121118.7
(22) Anmeldetag: 15.11.1989
(51) Int. Cl.: C23C 16/32, A47J 36/02

(54) **Kratzfester Gebrauchsgegenstand sowie Verfahren zu seiner Herstellung**
Abrasion-resistant consumer article and process for its manufacture
Objet courant résistant à l'abrasion et procédé pour sa fabrication

(30) Priorität: 17.11.1988 DE 3838905
(43) Veröffentlichungstag der Anmeldung: 20.06.1990
(73) Patentinhaber: Enke, Knut, Dr. Dipl.-Phys., D-63867 Johannesberg (DE)
(72) Erfinder: Enke, Knut, Dr. Dipl.-Phys., D-63867 Johannesberg (DE)
(74) Vertreter: Pöhner, Wilfried Anton, Dr.

(56) Entgegenhaltungen:
- EP-A- 0 193 998
- FR-A- 2 343 459
- US-A- 4 532 150
- US-A- 4 544 692
- US-A- 4 783 374
- THIN SOLID FILMS, Band 126, Nr. 3/4, April 1985, Seite 313, Lausanne, CH; R. BRÜTSCH: "Chemical vapour deposition of silicon carbide and its applications"
- JOURNAL OF VACUUM SCIENCE & TECHNOLOGY/SECTION A, Band 5, Nr. 5, September/Oktober 1987, Seite 2836, Woodbury, US; A. RAVEH et al.: "Characteristics of radio frequency silicon carbide films"
- THIN SOLID FILMS, Band 72, Nr. 3, Oktober 1980, Seite 497, Lausanne, CH; M. KATZ et al.: "Deposition of silicon carbide coatings on titanium alloy with a low pressure r.f. plasma"
- THIN SOLID FILMS, Bd. 107 (1983), Seiten 3-19

## Beschreibung

Die Erfindung bezieht sich auf einen kratzfesten Gebrauchsgegenstand, insbesondere Brat- oder Kochgeschirr, mit einer oberflächlich aufgebrachten Hartstoffschicht, bestehend aus Anteilen von Silicium Si und Kohlenstoff C sowie Verfahren zu seiner Herstellung.

Zur Verhinderung des Festklebens des Brat- oder Kochgutes am Boden von Pfanne oder Kochtopf ist im Stand der Technik bekannt entweder für den Verzehr geeignete Fette oder Öle zu verwenden oder diese Gegenstände mit Antihaftschichten auf PTFE-Basis zu versehen, die gemeinhin als Teflon, Silicon oder Silverstone bekannt sind. Wenn die Speisen aus gesundheitlichen Gründen fettarm zubereitet werden sollen, verbleibt nur noch die Verwendung beschichteten Geschirres.
Als entscheidender Nachteil ist anzusehen, daß beim Rühren mit Metallöffeln oder Schneiden des noch in der Pfanne befindlichen Bratgutes die relativ weiche und nicht sehr feste Antihaftschicht beschädigt wird, so daß das Geschirr innerhalb kürzester Zeit unbrauchbar wird.

Die EP-A-193 998 - ähnlich wie auch die Zeitschrift "Thin Solid Films" Bd. 126, Nr. 3/4, S. 313-318 - offenbart Schichten aus Siliciumcarbid (SiC). Die in der letzteren Schrift angegebenen Druckverhältnisse und gleichermaßen die in beiden Schriften angegebene einzustellende Temperatur liegen sehr hoch. Die Druckschrifen offenbaren klassische CVD-Verfahren, die auf ein pyrolytisches Abscheiden gerichtet sind und polykristalline Strukturen entstehen lassen.

In der US-A-4783374 enthalten die Beschichtungen Sauerstoffanteile, die zur Ausbildung von Silicium-oxycarbid-(Si-O-)Verbindungen Anlaß geben. Es entstehen quarzähnliche Strukturen, die optisch lichtdurchlässig sind.

Aus der US-PS 4 532 150 ist ein Verfahren zur Herstellung einer amorphen Siliciumcarbidschicht mit einem einstellbaren Siliciumanteil bekannt, wobei eine organische Siliciumverbindung durch das PCVD-Verfahren (plasmaangeregte chemische Dampfabscheidung) hergestellt wird. Auch die Zeitschrift "Journal of Vacuum Science and Technology" Bd. A5, Nr. 5 (1987), S. 2836-2841 offenbart, wie die Zeitschrift "Thin Solid Films" Bd. 72, Nr. 3 (1980), S. 497-501 Schichten aus Siliciumcarbid, die mit dem PCVD-Verfahren hergestellt werden.

Hiervon ausgehend hat sich die Erfindung die Schaffung kratzfester Gebrauchsgegenstände, insbesondere Brat- oder Kochgeschirr und ein Verfahren zu deren Herstellung zur Aufgabe gemacht.

Gelöst wird diese Aufgabe nach Anspruch 1 erfindungsgemäß dadurch, daß die Hartstoffschicht einen Anteil Wasserstoff von 1-50 Atomprozent aufweist, daß der Kohlenstoff diamantähnlich gebunden ist und daß der Kontaktwinkel der Hartstoffschicht für Wassertropfen mehr als 110 Grad beträgt.

Ein Verfahrenzur Herstellung derartiger Gebrauchsgegenstände ist in Anspruch 3 definiert.

Bevortugte Ausführungsformen werden in den Ansprüchen 2 bzw. 4-6 definiert

Kerngedanke der Erfindung ist die Aufbringung einer Schicht, die eine hohe Härte und Dichtigkeit, lso Freiheit von Poren und Korngrenzen besitzt und gleichzeitig eine große Haftfestigkeit an den zu beschichtenden Gegenständen. Andererseits soll das zu bratende, backende oder kochende Gut jedoch nicht anhaften.

Die Anwendung des erfindungsgemäßen Gedankens ist auf die unterschiedlichsten sowohl metallischen als auch nichtmetallischen Gegenstände möglich. Insbesondere eignen sich hierfür Bratpfannen, Kochtöpfe, Backformen oder aber auch Stanz- oder Umformwerkzeuge. Grundsätzlich gilt, daß auf manchen Materialien, zu denen einige Metalle, vor allem aber auch Stahl sowie Keramik zählen, Kohlenstoff nur wenig anhaftet. Der Erfindung liegt die unerwartete Erkenntnis zugrunde, daß bereits geringe Beimischungen von unter Umständen nur wenigen Prozenten Silicium und Wasserstoff zum Kohlenstoff ausreicht, um die Haftung ganz wesentlich zu erhöhen. Hierbei werden die mechanischen Eigenschaften der Schicht nicht nachteilig beeinflußt. Die Härte und Widerstandsfähigkeit der Schicht wird durch die (teilweise) diamantähnlichen Bindungen und Strukturen hervorgerufen.
Als weiterer erheblicher Vorzug hat sich hierbei gezeigt, daß sich der Kontaktwinkel der Wassertropfen auf diesen Schichten gegenüber den reinen aus amorphen Kohlenstoffen bestehenden von einem Wert etwa unter 70 Grad bis auf über 100 Grad erhöht. Man beobachtet eine deutliche Verbesserung der wasserabstoßenden Wirkung. Dieses hydrophobe Verhalten ist um so erstaunlicher, als man fast nur bei kohlenstoff- und fluorhaltigen Materialien, wie z.B. beim bekannten PTFE (Teflon) derartige Wirkungen beobachtet.

In einer vorteilhaften Weiterbildung ist vorgesehen, nur die unterste unmittelbar am Gegenstand anhaftende Schicht (Grundschicht) durch Abscheiden von Kohlenstoff mit Silicium herzustellen und für die darüber befindliche dickere Schicht Siliciumfreien Kohlenstoff oder aber einen von der Grundschicht abweichenden Siliciumanteil vorzusehen. Im Ergebnis erhält man einen aus mehreren Lagen bestehenden Aufbau der Hartstoffschicht.

Als Verfahren zur Herstellung der Hartstoffschichten auf den Gebrauchsgegenständen wird das an sich bekannte Verfahren der plasmaangeregten chemischen Dampfabscheidung (Plasma-activated chemical vapor deposition, PACVD, PCVD) vorgeschlagen. Durch eine Glimmentladung (synonym für Plasma) entsteht ein Ionenbeschuß des Gegenstandes, der eine harte, elektrisch isolierende Kohlenstoffschicht mit diamantähnlichen Eigenschaften entstehen läßt. Grundsätzlich ließe sich die Glimmentladung mit einer Aufheizung optimieren, was als plasma-unterstütztes CVD bezeichnet wird. Bei einem konventionellen CVD-Verfahren werden die zu beschichtenden Teile auf Temperaturen von mehreren 100 bis über 1000 Grad aufgeheizt. Mit einem derartigen, auch als Pyrolyse bezeichneten Verfahren läßt sich in einer Kohlenwasserstoffatmosphäre Kohlenstoff abscheiden, der jedoch dann graphitähnliche Eigenschaften aufweist, also weich, undurchsichtig und elektrisch leitfähig ist. Grundsätzlich ist diese Aufheizung jedoch nicht erforderlich, weshalb sogar gegen hohe Temperaturen empfindliche Kunststoffe mit Hilfe der Glimmentladung beschichtet werden können. Die Abscheidetemperatur liegt dann so niedrig, daß in vorteilhafter Weise bei Anwendung des PCVD-Verfahrens die mechanischen Eigenschaften des zu beschichtenden Stahles erhalten bleiben und ein "Ausglühen" mit Sicherheit nicht stattfindet. Weiter ist als Vorzug anzusehen, daß gegenüber anderen Vakuum-Abscheideverfahren auch dreidimensionale Bauteile wie Backformen, Töpfe und Umformwerkzeuge allseitig ohne komplizierte Rotationsvorrichtungen gleichmäßig beschichtbar sind.
Für die Glimmentladung benötigt man außer elektrischer Energie auch Gas aus einem Druckbereich von Zehntausendstel bis einigen mbar innerhalb der Beschichtungskammer. Während des Prozesses der selbständigen Glimmentladung wird das Gas teilweise chemisch angeregt, ionisiert und im Falle mehratomiger Gase dissoziiert und in Radikale zerlegt. Die restlichen Atome bzw. Moleküle bleiben neutral. Als Gase werden silicium-, kohlen- und wasserstoffhaltige Verbindungen eingesetzt. Insbesondere kann es sich um ein Gas aus der großen Gruppe der siliciumorganischen Verbindungen handeln. Bei vielen chemischen Verbindungen dieser Art lassen sich auch Flüssigkeiten verwenden deren Dampfdruck häufig schon bei Zimmertemperatur so hoch ist, daß sie allein durch den Unterdruck in die Beschichtungskammer hineingesogen werden.

Als besonders geeignete Gase werden vorgeschlagen Silan, Tetrafluorkohlenstoff, Tetramethylsilan Hexamethyldisilan, Hexamethyldisiloxan, Hexamethyldisilazan, Vinyldimethylethoxysilan, Tetraethoxysilan oder irgendwelche andere methyl-, vinyl-, phenyl- oder alkoxygruppenhaltigen Siloxane, Silazane oder Silane. Hierzu zählen auch die halogenierten Ensprechungen wie Dichlormethylsilan und Trifluorosilan. Wichtig ist, daß bei Vorliegen von Halogenen Wasserstoff in hinreichender Menge zugesetzt wird. Andernfalls würde man das nicht erwünschte plasmachemische Ätzen erhalten. Bei einem Gemisch von beispielsweise Tetrachlorsilan und Tetrafluorkohlenstoff läßt sich in einem weiten Bereich von elektrischer Leistung und Gasdruck eine Ätzung erwarten, wohingegen bei Ersatz von Tetrachlorsilan durch Silan aus diesem Gasgemisch eine SiC-ähnliche harte Schicht entsteht. Der Wasserstoff verbindet sich mit dem Fluor zu HF-Gas, das durch die Pumpen entfernt wird.
Für die Erfindung ist ohne Belang, in welcher Molekülstruktur die Prozeßgase vorliegen, ob es sich also um lineare, verzweigte oder ringförmige Strukturen handelt. Beim Aufprall auf den Probenhalter bzw. das dort befindliche und zu beschichtende Werkstück verlieren die Moleküle ihre ursprüngliche Struktur.
Es ist auch möglich, als Siliciumspender anorganische Gase, wie z.B. Silan oder Tetrafluorsilan zu verwenden.
Nur am Rande sei erwähnt, daß sich bei Zugabe von Edelgasen eine Kathodenzerstäubungs(Sputter) - Anlage ergibt, in der der Probenhalter und der daran befestigte Gegenstand durch Ionenbeschuß geätzt wird, wodurch eine Möglichkeit der Reinigung des Werkstückes vor der eigentlichen Beschichtung gegeben ist.

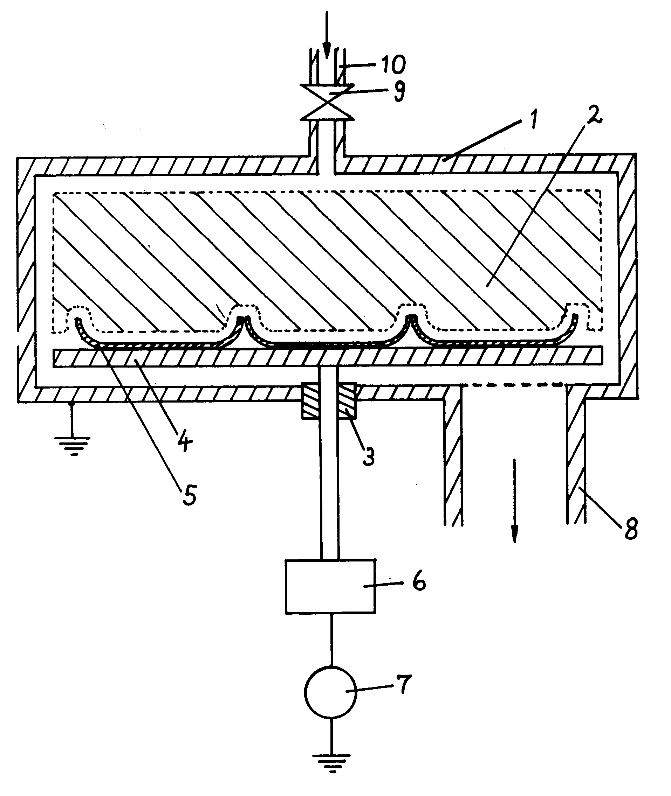

Weitere Einzelheiten, Merkmale und Vorteile der Erfindung lassen sich dem nachfolgenden Beschreibungsteil entnehmen, indem anhand der Zeichnung ein Ausführungsbeispiel zur Durchführung des erfindungsgemäßen Verfahrens in schematisch gehaltener Querschnittsdarstellung wiedergegeben ist.

In dem durch die Rezipientenwand (1) umgrenzten Innenraum befindet sich eine Halterung (4) mit darauf angeordnetem Werkstück (5). Sie ist über eine elektrisch isolierte Durchführung (3) über den Impedanzwandler (6) mit einem Hochfrequenzgenerator (7) zur elektrischen Energieversorgung verbunden.

In dem durch das Werkstück (5) und einen Teil der Rezipientenwand (1) umgrenzten Raum, der in der Zeichnung mit punktierter Linie begrenzt ist, gehen Glimmentladungen vonstatten, durch die das Niederschlagen der Kohlenstoff und Silicium enthaltenen Schichten auf der Oberfläche des Werkstückes erfolgt.

Zu diesem Zweck wird der Innenraum mit Hilfe des Rohres (8) über eine hier nicht gezeigte Einrichtung so weit evakuiert, daß sich eine selbständige Glimmentladung ausbildet, d.h. daß das Gas teilweise chemisch angeregt, ionisiert und bei mehratomigen Gasen dissoziiert und in Radikale zerlegt wird. Bei der Evakuierung ist das Rohr (10) über das Ventil (9) geschlossen. Erst anschließend wird das Ventil geöffnet und das jeweils verwendete Prozeßgas bis zum benötigten Druck eingelassen. Dann erst entsteht durch Ionenbeschluß an der Oberfläche des Werkstückes (5) die gewünschte kratzfeste Hartstoffschicht.

Im Ergebnis ist durch die gezeigte Vorrichtung die Durchführung eines Verfahrens möglich, mit dessen Hilfe sich an der Oberfläche von Gebrauchsgegenständen hochkratzfeste und hydrophobe Hartstoffschichten herstellen lassen.

## Patentansprüche

1. Kratzfester Gebrauchsgegenstand, insbesondere Brat- oder Kochgeschirr mit einer oberflächlich aufgebrachten Hartstoffschicht, bestehend aus Anteilen von Silicium Si und Kohlenstoff C, **dadurch gekennzeichnet**, daß die Hartstoffschicht einen Anteil Wasserstoff von 1-50 Atomprozent aufweist, daß der Kohlenstoff diamantähnlich gebunden ist und daß der Kontaktwinkel der Hartstoffschicht für Wassertropfen mehr als 110 Grad beträgt.

2. Gebrauchsgegenstand nach Anspruch 1, **gekennzeichnet durch** eine zusätzliche äußere Schicht frei von oder mit einem anderen Anteil an Silicium.

3. Verfahren zur Herstellung eines Gegenstandes nach Anspruch 1 oder 2, bei dem durch ein Plasma-CVD-Verfahren innerhalb eines Vakuumrezipienten eine chemische Dampfabscheidung gasförmiger oder verdampfbarer Verbindungen oder Gemische, die Kohlenstoff, Wasserstoff und Silicium enthalten, auf ein Substrat duchgeführt wird, **dadurch gekennzeichnet**, daß der Gasdruck, der relative Anteil der Kohlenstoff-, Wasserstoff- und Siliciumatome im Gas sowie die zugeführte elektrische Leistung oder die Kathodenspannung derart variiert wird, daß der Wasserstoffanteil in der abgeschiedenen Schicht zwischen 1 und 50 Prozent liegt und der Kontaktwinkel für Wassertropfen mehr als 110 Grad beträgt.

4. Verfahren nach Ansprch 3, **dadurch gekennzeichnet**, daß bei Vorhandensein von Halogenen im Gas Wasserstoff in einer ausreichenden Menge beigegeben ist.

5. Verfahren nach Anspruch 3 oder 4, **gekennzeichnet durch** die Gase Silan, Tetrafluorkohlenstoff, Tetramethylsilan, Hexymethyldisilan, Hexamethyldisiloxan, Hexamethyldisilazan, Vinyldimethylethoxysilan, Tetraethoxysilan oder irgendwelcher anderen methyl-, vinyl-, phenyl- oder alkoxygruppenhaltigen Siloxane, Silazane oder Silane oder deren halogenierten Verbindungen, wie z.B. Dichlormethylsilan oder Trifluorosilan.

6. Verfahren nach einem der Ansprüche 3 bis 5, **dadurch gekennzeichnet**, daß der Gasdruck im Rezipienten zwischen 10⁻⁴ und einigen mbar beträgt.

## Claims

1. Scratch resistant article of daily use, especially frying and cooking ware, having a hard material coat applied to the surface, consisting of components of silicon Si and carbon C, **wherein** said hard material coat has a hydrogen atom percentage content of 1 - 50, that the carbon is combined like a diamond and that the contact angle of the hard material coat for water drops is more than 110 degrees.

2. Article of daily use according to claim 1, **wherein** there is an additional outer coat free of or with a different share of silicon.

3. Method to manufacture an object according to claim 1 or 2 whereby through a plasma CVD process within a vacuum recipient a chemical vapour deposition of gaseous or vaporable compounds or mixtures which contain carbon hydrogen and silicon is executed on a substrate, **wherein** the gas pressure, the relative share of carbon, hydrogen, and silicon atoms in the gas as well as the fed-in electrical power or the cathode voltage is varied in such a way that the hydrogen content in the deposited coat lies between 1 and 50 per cent and the contact angle for water drops is more than 110 degrees.

4. Method according to claim 3, **wherein** if halogens exist in the gas, hydrogen is added in a sufficient quantity.

5. Method according to claim 3 or 4, **wherein** the gases are silane, carbon tetrafluoride, tetramethylsilane, hexamethyldisilane, hexamethyldiloxane, hexamethyldisilazane, vinyldimethylethoxysilane, tetraethoxysilane or any other siloxanes, silizanes, silanes containing the methyl, vinyl, phenyl or alkoxy groups or their halogenated groups such as dichloromethylsilane and trifluorosilane.

6. Method according to one of claims 3 to 5, **wherein** the gas pressure in the recipient lies between 10⁻⁴ and several mbar.

## Revendications

1. Objet d'usage courant résistant à l'abrasion, en particulier poêle à frire ou ustensile de cuisson, comportant un revêtement en matériau dur rapporté à sa surface, consistant de pourcentages de silicium Si et de carbone C, **caractérisé en ce que** le revêtement en matériau dur comporte un pourcentage d'hydrogène de 1-50 pour-cent atomiques, en ce que le carbone est structuré d'une façon similaire au diamant et que l'angle de contact du revêtement en matériau dur pour des gouttes d'eau est supérieur à 110 degrés.

2. Objet d'usage courant selon la revendication 1, **caractérisé par** une couche externe supplémentaire qui ne contient pas de silicium ou du moins avec un pourcentage en silicium différent.

3. Procédé de fabrication d'un objet selon l'une des revendications 1 ou 2, par lequel un dépôt chimique en phase vapeur de liaisons gazeuses ou évaporables ou de mélanges, qui contiennent du carbone, de l'hydrogène et du silicium est effectué sur un substrat par un procédé CVD au plasma dans une enceinte à vide, **caractérisé en ce que** la pression gazeuse, la proportion relative des atomes de carbone, d'hydrogène et de silicium dans le gaz, ainsi que l'énergie électrique fournie ou la tension de cathode sont ajustées de telle sorte que le pourcentage d'hydrogène dans la couche déposée est compris entre 1 et 50 pour-cent et l'angle de contact pour des gouttes d'eau est supérieur à 110 degrés.

4. Procédé selon la revendication 3, **caractérisé en ce que** lorsque des halogènes sont présents dans le gaz, de l'hydrogène doit être ajouté en quantité suffisante.

5. Procédé selon la revendication 3 ou 4, **caractérisé par** les gaz silane, tétrafluoréthylène, tétraméthylsilane, hexaméthyldisilane, hexaméthyldisiloxane, hexaméthyldisilazan, vinyldiméthylethoxysilane, tétraethoxysilane ou n'importe quelle autre liaison de siloxane, silazan ou silane avec des groupes méthyl-, vinyl- phényle- ou alcoxyle ou leurs liaisons halogénées, comme par exemple le dichlorométhylsilane ou le trifluorosilane.

6. Procédé selon l'une des revendications 3 à 5, **caractérisé en ce que** la pression de gaz dans l'enceinte est de l'ordre de 10⁻⁴ à quelques mbar.
